(19) Europäisches Patentamt
European Patent Office
Office européen des brevets

(11) Publication number: **0 384 448 A2**

(12) # EUROPEAN PATENT APPLICATION

(21) Application number: **90103394.4**

(51) Int. Cl.5: **H03H 17/02**

(22) Date of filing: **22.02.90**

(30) Priority: **23.02.89 JP 41892/89**

(43) Date of publication of application:
**29.08.90 Bulletin 90/35**

(84) Designated Contracting States:
**DE FR GB IT NL**

(71) Applicant: **LSI LOGIC CORPORATION**
**1551 McCarthy Boulevard**
**Milpitas, CA 95035(US)**

(72) Inventor: **Kontani,Tetsuro**
**Res. Green Stream 305 37-9, Azamino**
**4-chome**
**Midori-ku, Yokohama-shi Kanagawa 227(JP)**

(74) Representative: **Thiel, Christian et al**
**Patentanwälte**
**Herrmann-Trentepohl,Kirschner, Grosse,**
**Bockhorni, Schaeferstrasse 18**
**D-4690 Herne 1(DE)**

(54) **Digital filter.**

(57) A digital filter comprised of digital filter modules, characterized in that anomalous signals produced at filter taps are logic-processed to produce a signal which enables detection of anomalies in the digital filter.

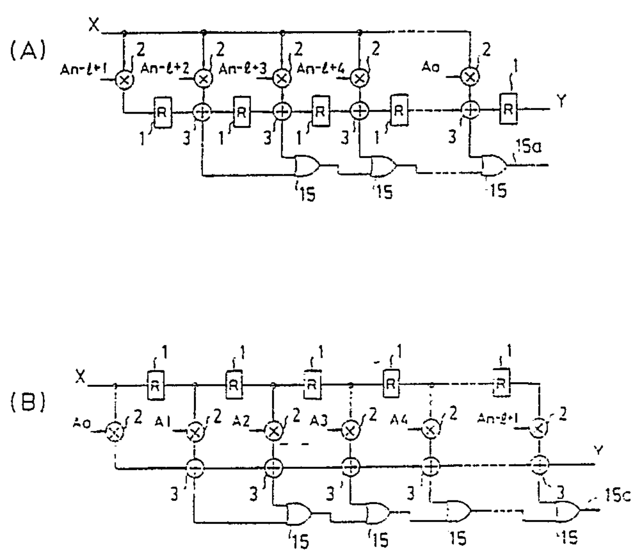


Fig. 1

EP 0 384 448 A2

# Digital filter

## Field of invention

The present invention relates to a digital filter, and more particularly to a digital filter such as a transversal filter, which is comprised of digital filter modules and provided with a function to detect the occurrence of anomalies such as overflow ( a state in which excessively large or small absolute values exceeding an allowable limit are produced during arithmetic operations ).

## Description of the prior art

A transversal filter, also referred to as a tapped delay line filter, provides an output signal derived by multiplying preceding input sample values obtained via delay elements by a filter coefficient and adding the signals obtained from each delay element. If Ai is the filter coefficient, X the input signal (sample value) series, Y the output signal series and the number of delay taps, this can be expressed mathematically by

$$Y(n) = \sum_{i=0}^{l-1} A_i \cdot X(n-i)$$

Figures 8 (A) and (B) show examples of the hardware configuration of transversal filters. In the drawings, reference numeral 1 denotes a delay element (R), 2 a multiplier and 3 an adder. A delay element 1, multiplier 2 and adder 3 constitute one tap.

Figure 8 (A) shows a transposed-type transversal filter and Figure 8 (B) a direct-type transversal filter. These filters multiply each of the signals input during a preceding sampling time by a predetermined filter coefficient and then add the signals to produce an output signal at a current time. The delay element 1 is constituted as an edge trigger shift register and the multiplier 2 is constituted as a memory register in which the filter coefficient is stored. In some arrangements a suitable pipeline register is provided between adders.

Some transversal filters use a sum-of-products computer such as the one shown in Figure 9 denoted by the reference numeral 4. These are differentiated from the filters illustrated in Figure 8 by whether the Xo of the data input to the filter can be derived bit by bit, or only the initial data of a data block.

In either embodiment, the output signal in the direct-type transversal filter can be expressed by

$Y(n) = A_o \bullet x_n + A_1 \bullet x_{n-1} + ...... + A_{l-1} \bullet x_{n-l+1}$

and in the transposed-type transversal filter by

$Y(n) = (A_o \bullet x_n + (A_1 \bullet X_{n-1} + (.... + (A_{l-1} \bullet X_{n-l+1})-))....)))$

In a digital filter the filtering is effected by digital processing. As this offers a high degree of precision and is suited to adaptive control and the like, digital filtering is used in many fields. Moreover, the recent advances in LSI technology enable such filters to be fabricated as single modules or as a combination of multiple modules which are compact and highly reliable.

As an example of adaptive control, an unknown system can be modeled by generating an error signal between a signal from the transversal filter and a signal from a target system and automatically adjusting the filter coefficients in accordance with this error signal (see pages 6 and 7 of "Introduction to Adaptive Filtering" published by Gendai Kogakusha 10 September 1987).

Transversal filters are also used in ghost cancelers. Ghosting is usually caused by a phenomenon that a television signal reflected by obstacles such as tall buildings and mountains is superimposed on a signal received directly, i.e., without being reflected by any such obstacle. That is, a ghost signal is produced by the propagation of the original transmission signal along various paths, causing a kind of modulation of the transmission time, amplitude and phase of the input signal. A ghost canceler cancels ghost signals by passing the input signal through a transversal filter in which the filter coefficient can be varied.

A method for inserting a ghost-cancelling reference signal in the broadcast signal to control ghost cancelers is described in an article entitled "Inserting a ghost-canceler-control reference signal in the television broadcast signal" published in issue number 432 of Nikkei Electronics, 9 September 1987, page 220.

The principle involved is illustrated in Figure 10. An input signal f(t) is input directly into an adder 11, and is also input into a one-dimensional transversal filter 10 whose output signal is added to the original input signal by the adder 11. The output of the adder 11 is fed into a filter coefficient controller 12, which receives a reference signal Ref. To cancel the ghost signals described above, the filter coefficients of the transversal filter 10 are adjusted so that the output signal derived from the adder 11 within a period of insertion of the ghost-cancelling reference signal into the input signal f(t) may coincide with the reference signal Ref.

Ghost signals will be dependent on the various physical conditions of the signal propagation path

on the transmission and receiving sides. Such conditions include the presence of structures, vibration, the angles concerned, reflection of the waves, vibration of the transmitting and/or receiving antennas, wind direction and wind speed, temperature, humidity and other three-dimensional physical conditions. Therefore, to prevent the appearance of ghost signals, it is required to use an adaptive control to change the coefficients of the transversal filter 10 from moment to moment.

Task to be solved by the Invention

Such a transversal filter is usually realized as a single LSI chip or module, or as a plurality of the same type of LSI chips or modules with a plurality of taps provided in the LSI chips. Overflow can occur unless the transversal filter is arranged in such a manner that the adder nearest the output side has a higher number of bits. However, as in an ordinary transversal filter the bit width and bit range of the adder of each tap is fixed, there would occur an overflow at each tap of the transversal filter. The occurrence of overflow or other such anomalies can lead to generation of an inaccurate output signal at the tap concerned, thus making the predetermined filter characteristics unobtainable. Overflow therefore gives rise to the problem of how it should be communicated to the system, and how the system should respond.

As conventional transversal filters lack means for dealing with such anomalies, the occurrence of such anomalies has either rendered the predetermined characteristics unobtainable or has caused the entire system to malfunction.

The object of the present invention is to solve the above problems by providing an anomaly detector in a digital filter that enables overflow and other anomalies to be detected promptly in order to take corresponding measures.

Means for solving the task

To solve the above problems, the present invention uses an arrangement in a digital filter comprised of digital filter modules, characterized in that anomalous signals produced at filter taps are logic-processed to produce a signal which enables detection of anomalies in the digital filter.

The present invention uses another arrangement in a digital filter comprised of a plurality of digital filter modules, characterized in that anomalous signals produced in one of the digital filter modules are logic-processed to produce an anomalous signal in the module, and that the anomalous signals from each of the modules are then logic-processed for detection of anomalies in the digital filter.

Operation

A digital filter such as a transversal filter, for example, is provided with taps corresponding to the number of adders. When an anomaly such as overflow arises in an adder, an anomalous signal is produced at the corresponding tap. In the present invention, anomalies in the digital filter are detected from signals obtained by subjecting anomalous signals arising at the taps to logic-processing.

Description of the Embodiments

Details of the present invention will now be described with reference to the embodiments illustrated in the drawings.

As has been mentioned, transversal filters are realized as a single module or as a plurality of modules. Figures 1 to 3 illustrate an embodiment of a transversal filter configured as a single module. Elements that are the same as those in a conventional arrangement are denoted by the same reference numerals, and the description of such elements is omitted.

Figure 1 (A) shows a transposed-type transversal filter and Figure 1 (B) a direct-type transversal filter. In each filter, the logical sum of overflows arising at the taps, that is, of adders 3 is obtained. The logical sum of the preceding adders 3 is input to an OR circuit 15 together with the logical sum of the next adder.

With such an arrangement, if an overflow is produced at any tap, there will be an H-level overflow output signal, for example, in an output 15a of a final stage OR circuit 15, enabling the overflow output to be communicated to the system regardless of the existence or non-existence of registers between taps. Even when the system takes time to respond to the overflow output, prompt countermeasures are possible.

With the embodiment of Figure 1 it is not possible to analyze which tap an overflow originates from, but with some systems it is necessary to be able to specify the tap. For such cases, an arrangement can be employed in which the tap from which an overflow comes can be found by providing the modules with overflow flag flip-flops for each of the taps and reading the flag value.

Figures 2 (A) and (B) show a second embodiment of the invention for detecting overflow in transposed- and direct-type transversal filters.

This embodiment can be used when the overflow from the taps is produced from an open drain

or open collector. The outputs of the adders are connected to a wired OR circuit 16. As any overflow produced at a tap will show up as an overflow output at the output terminal 16a which provides an input to the system, the overflow can be sensed.

Figure 3 shows another embodiment in which an overflow flag 17 is provided that receives signals from an OR circuit 18 connected to the adder 3 of each tap. In the case of this embodiment, if an overflow arises at one of the taps, the overflow output is stored by the corresponding flag, so overflows are transferred toward the system in the sequence of the taps producing the overflow. Thus, the register value at the time the overflow output 17a from the final stage is communicated to the system becomes unreliable. Taps having a coefficient of zero may be replaced by a parallel shift register.

The above-described embodiment employs a single module transversal filter arrangement. When a multiple module arrangement is used, the logical sum of the overflow of the taps of each module is derived followed by the logical sum of the modules, enabling the overflow of the overall system to be detected.

Figure 4 shows a transversal filter 20 implemented as a single module type transversal filter, corresponding to the transversal filters shown in Figures 1 to 3. The logical sum of the outputs of the taps 21 is derived by the OR circuit 23, using the same method illustrated in Figures 1 to 3. This enables the overflow produced at any tap to appear at an output terminal 23a of an OR circuit 23.

Figure 5 shows an example in which the overflow output from the modules 20 is an open drain type. The logical sum of the modules 20 can be output using an OR gate 24. In this case, the number of leads used will be the number of modules plus the number of lines of the wired OR bus. However, one wired OR resistor 25 is required.

The open drain arrangement means that the module that produced an overflow cannot be detected directly. Therefore, as shown in Figure 6, a resistor or a diode 26 is used to isolate the output of each of the modules, the logical sum of the isolated outputs is derived by an OR gate 27 and the overflow outputs of the modules are input to an analysis logic circuit 28 to identify which module an overflow came from.

In the embodiment shown in Figure 7, the overflow output from the transversal filter modules is implemented as a push-pull type. Use of an active element such as a logic IC is required to obtain the logical sum of the outputs of the modules 20. As the overflow output of a module is not subjected to interference from other modules, a push-pull arrangement enables the module that produced a given overflow to be readily ascertained. The analysis logic circuit 28 used for this purpose need not be provided from the outset. Instead, a printed circuit board can be arranged to allow for the later addition of the analysis logic circuit 28 when required.

The present invention is not limited to a transversal filter but may be applied to other digital filters, such as a cyclic filter of Figure 11, a lattice filter of Figure 12 and a bi-quad filter of Figure 13.

While the anomaly described in the foregoing embodiments is overflow arising in a transversal filter, the invention is not limited to the detection of overflow. Instead, the same arrangements can be used to detect other anomalies, such as anomalies arising in the multiplier, for example.

The transversal filter modules in the embodiments described above can be realized as integrated circuit chips, as discrete circuits, or as hybrid circuits that combine both types.

Effect of the invention

As has been described in the foregoing, the present invention uses an arrangement in a digital filter comprised of digital filter modules, wherein anomalous signals produced at filter taps are logic-processed to produce a signal which enables detection of anomalies in the digital filter. This arrangement enables overflow and other anomalies to be promptly detected and communicated to the system and countermeasures to be implemented.

4. Brief description of the drawings

Figures 1 (A) and (B), Figures 2 (A) and (B) and Figure 3 each show a transversal filter using a single module; Figure 4 is a block diagram of one module of the transversal filter; Figures 5 to 7 are circuit diagrams of different embodiments of transversal filters using a plurality of modules; Figures 8 (A) and (B) and Figure 9 are circuit diagrams of conventional transversal filter arrangements; Figure 10 is a block diagram of a ghost canceler; Figure 11 shows a cyclic filter to which the invention is applied; Figure 12 shows a lattice filter to which the invention is applied; and Figure 13 shows a bi-quad filter to which the invention is applied.

1 Delay element
2 Adder
3 Multiplier
15 OR circuit
20 Transversal filter module
28 Overflow analysis logic circuit

**Claims**

1. A digital filter comprised of digital filter modules, characterized in that anomalous signals produced at filter taps are logic-processed to produce a signal which enables detection of anomalies in the digital filter.

2. A digital filter comprised of a plurality of digital filter modules, characterized in that anomalous signals produced in one of the digital filter modules are logic-processed to produce an anomalous signal in the module, and that the anomalous signals from each of the modules are then logic-processed for detection of anomalies in the digital filter.

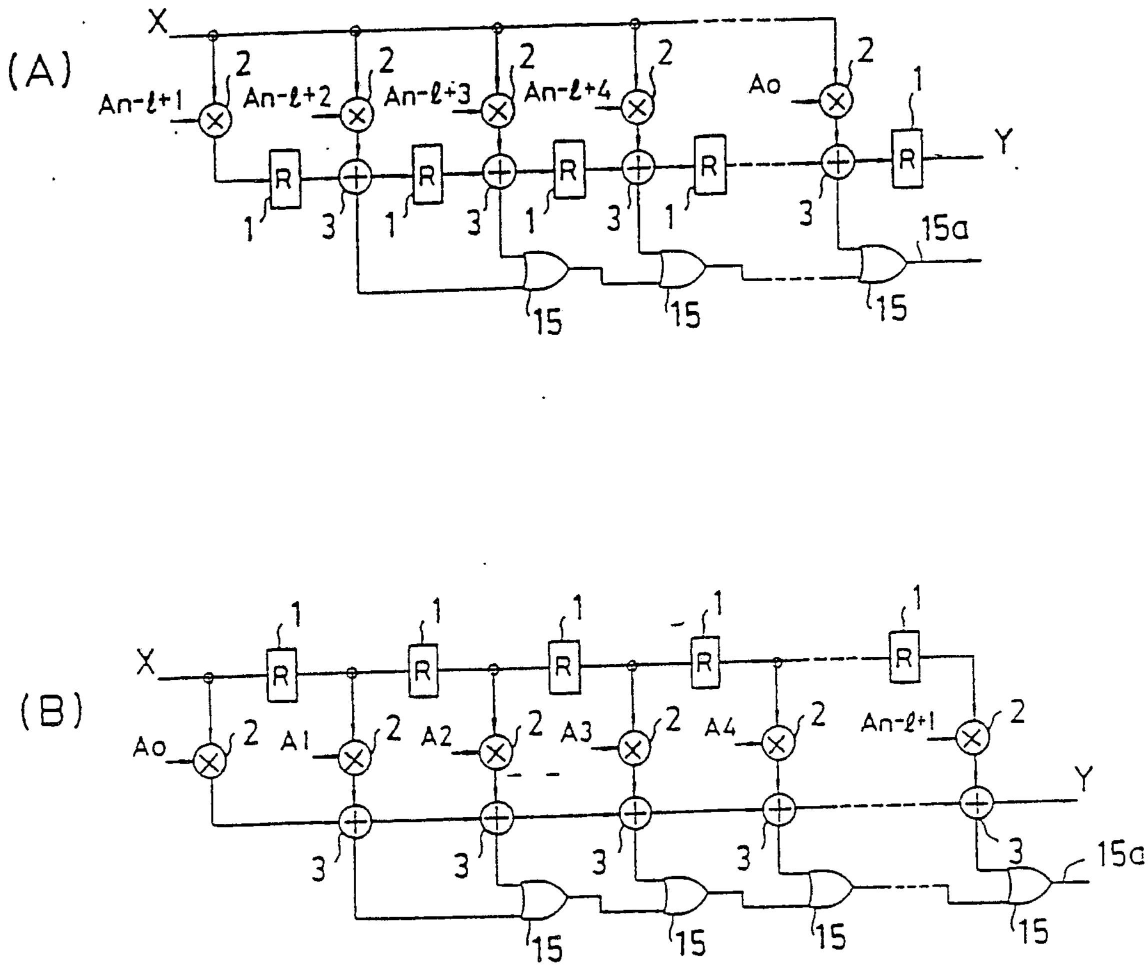


Fig. 1

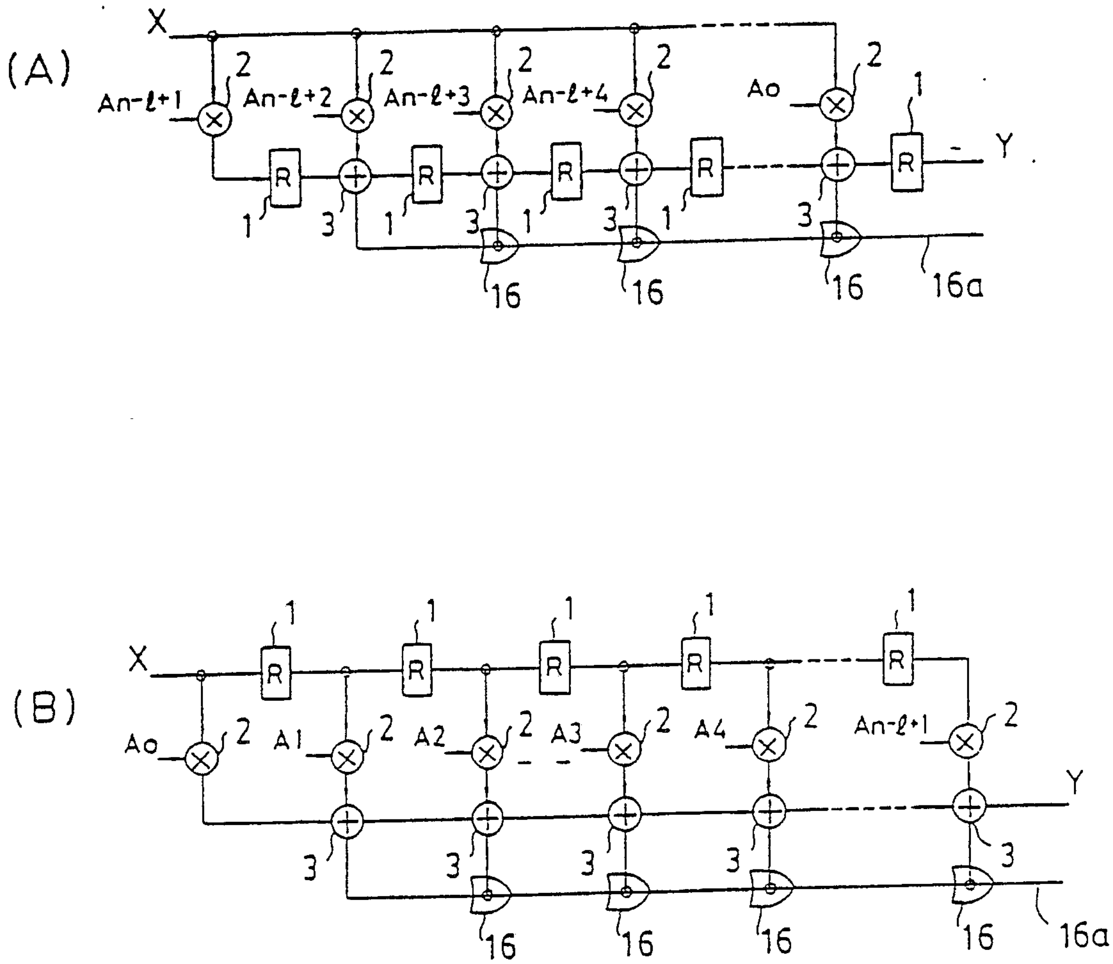


Fig. 2

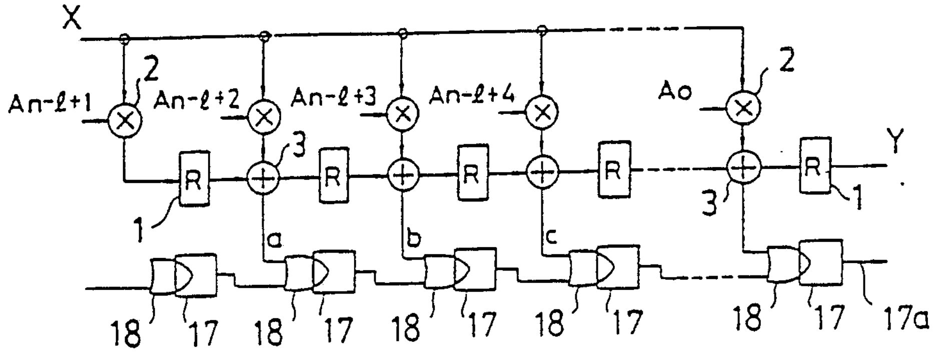


Fig. 3

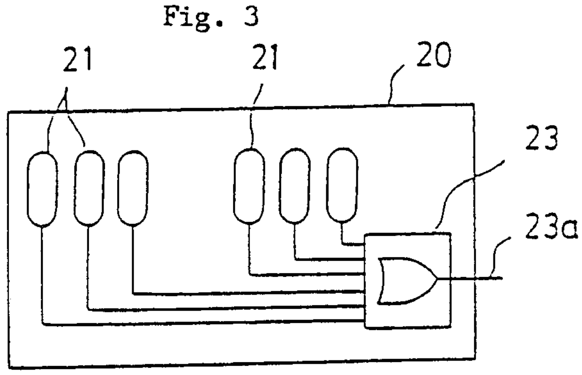


Fig. 4

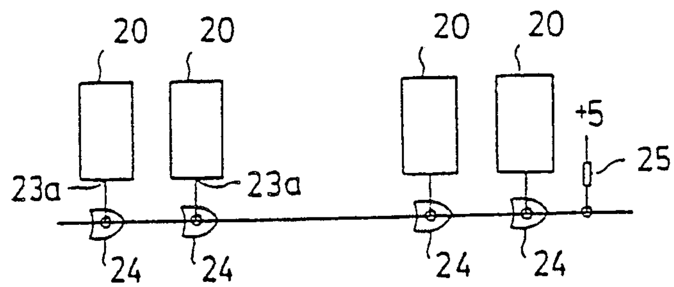


Fig. 5

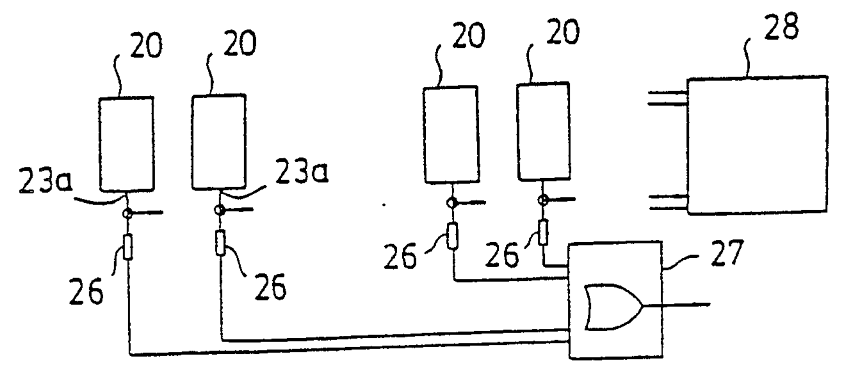


Fig. 6

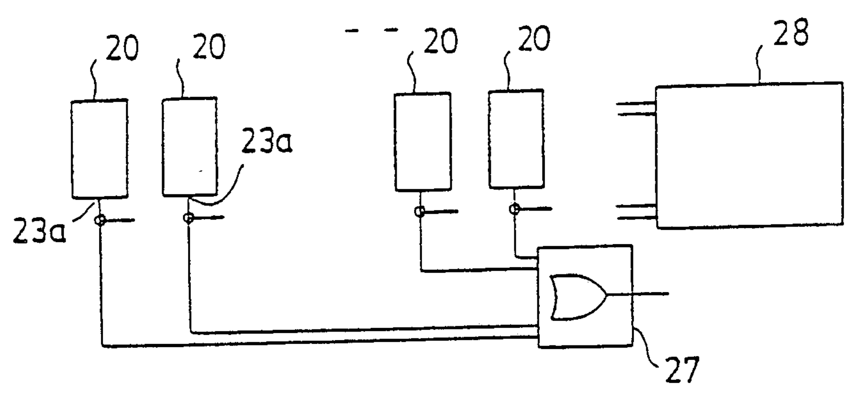


Fig. 7

(A)

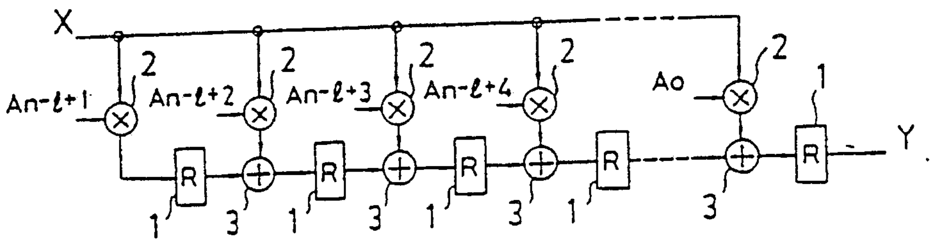


(B)

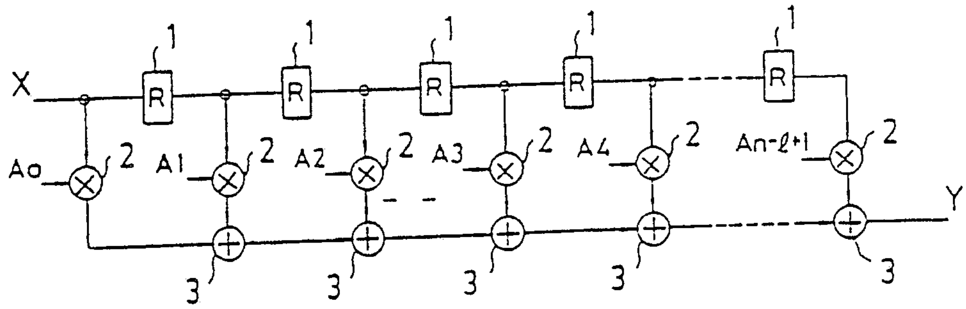


Fig. 8

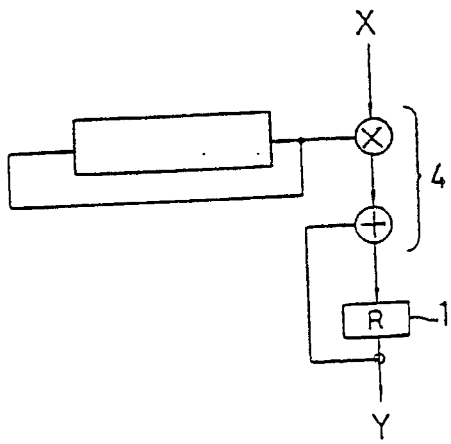


Fig. 9

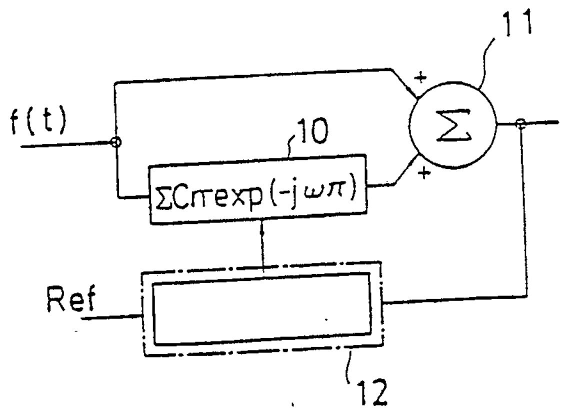


Fig. 10

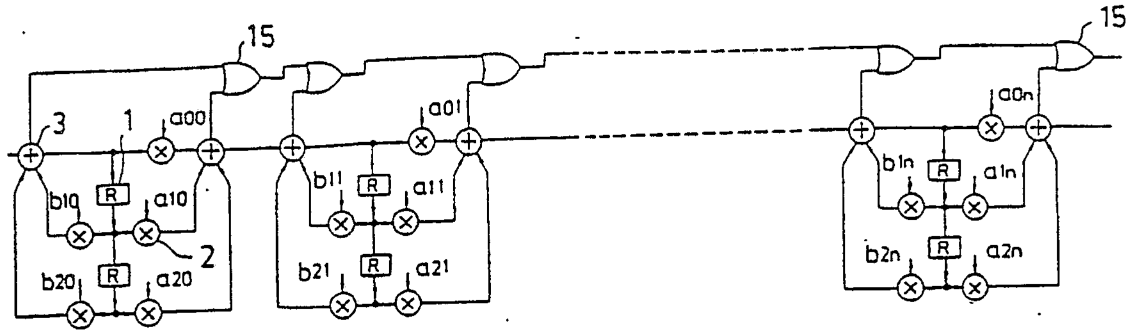


Fig. 13

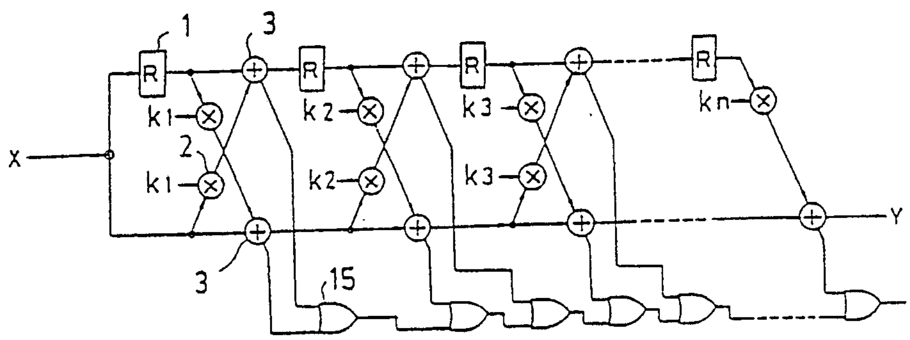


Fig. 12

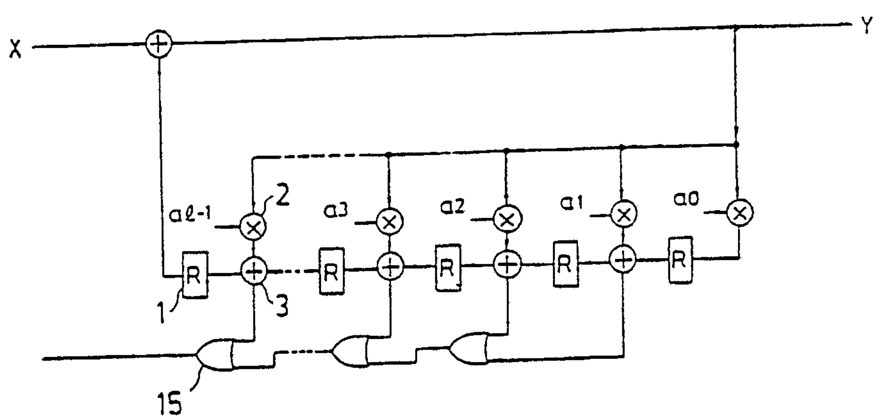


Fig. 11